# EUROPÄISCHE PATENTSCHRIFT

(11) **EP 1 155 498 B1**
(45) Veröffentlichungstag und Bekanntmachung des Hinweises auf die Patenterteilung: **10.03.2004**
(21) Anmeldenummer: 00912430.6
(22) Anmeldetag: 17.01.2000
(51) Int. Cl.: H03M 7/40

(54) **VORRICHTUNG UND VERFAHREN ZUM ERZEUGEN EINES DATENSTROMS UND VORRICHTUNG UND VERFAHREN ZUM LESEN EINES DATENSTROMS**
DEVICE AND METHOD FOR GENERATING A DATA FLOW AND DEVICE AND METHOD FOR READING A DATA FLOW
DISPOSITIF ET PROCEDE POUR PRODUIRE UN FLUX DE DONNEES, ET DISPOSITIF ET PROCEDE POUR LIRE UN FLUX DE DONNEES

(30) Priorität: 23.02.1999 DE 19907728
(43) Veröffentlichungstag der Anmeldung: 21.11.2001
(73) Patentinhaber: Fraunhofer-Gesellschaft zur Förderung der angewandten Forschung e.V., 80686 München (DE)
(72) Erfinder: SPERSCHNEIDER, Ralph, D-91056 Erlangen (DE); DIETZ, Martin, D-90408 Nürnberg (DE); HOMM, Daniel, D-91052 Erlangen (DE); BÖHM, Reinhold, D-90469 Nürnberg (DE)
(74) Vertreter: Schoppe, Fritz, Dipl.-Ing.
(86) Internationale Anmeldenummer: PCT/EP2000/000314
(87) Internationale Veröffentlichungsnummer: WO 2000/051242

(56) Entgegenhaltungen:
- EP-A- 0 612 156
- DE-A- 19 747 119

## Beschreibung

Die vorliegende Erfindung bezieht sich auf das Codieren mit Codeworten variabler Länge und insbesondere auf gegen Übertragungsfehler robuste Datenströme mit Codewörtern variabler Länge.

Moderne Audiocodierverfahren bzw. -decodierverfahren, die beispielsweise nach dem Standard MPEG-Layer 3 arbeiten, sind in der Lage, die Datenrate von Audiosignalen beispielsweise um einen Faktor 12 zu komprimieren, ohne die Qualität derselben merkbar zu verschlechtern. Um eine derartig hohe Datenratenreduktion zu erreichen, wird ein Audiosignal abgetastet, wodurch eine Folge von zeitdiskreten Abtastwerten erhalten wird. Wie es in der Technik bekannt ist, wird diese Folge von zeitdiskreten Abtastwerten mittels geeigneter Fensterfunktionen gefenstert, um gefensterte Blöcke von zeitlichen Abtastwerten zu erhalten. Ein Block zeitlich gefensterter Abtastwerte wird dann mittels einer Filterbank, einer modifizierten diskreten Cosinustransformation (MDCT) oder einer anderen geeigneten Einrichtung in den Frequenzbereich transformiert, um Spektralwerte zu erhalten, die insgesamt das Audiosignal, d. h. den zeitlichen Ausschnitt, der durch den Block von zeitdiskreten Abtastwerten gegeben ist, im Frequenzbereich darstellen. Üblicherweise werden sich zu 50% überlappende zeitliche Blöcke erzeugt und mittels einer MDCT in den Frequenzbereich transformiert, wodurch aufgrund der speziellen Eigenschaften der MDCT immer beispielsweise 1024 zeitdiskrete Abtastwerte zu 1024 Spektralwerten führen.

Es ist bekannt, daß die Aufnahmefähigkeit des menschlichen Ohrs vom Augenblicksspektrum des Audiosignals selbst abhängt. Diese Abhängigkeit ist in dem sog. psychoakustischen Modell erfaßt, mittels dem es seit längerem möglich ist, abhängig vom augenblicklichen Spektrum Maskierungsschwellen zu berechnen. Maskierung bedeutet, daß ein bestimmter Ton bzw. Spektralanteil verdeckt wird, wenn beispielsweise ein benachbarter Spektralbereich eine relativ hohe Energie besitzt. Diese Tatsache der Maskierung wird ausgenutzt, um die nach der Transformation vorhandenen Spektralwerte möglichst grob zu quantisieren. Es wird daher angestrebt, einerseits hörbare Störungen im wieder decodierten Audiosignal zu vermeiden und andererseits möglichst wenig Bits zu verwenden, um das Audiosignal zu codieren bzw. hier zu quantisieren. Die durch die Quantisierung eingeführten Störungen, d. h. das Quantisierungsrauschen, soll unter der Maskierungsschwelle liegen und somit unhörbar sein. Gemäß bekannter Verfahren wird daher eine Einteilung der Spektralwerte in sog. Skalenfaktorbänder durchgeführt, die den Frequenzgruppen des menschlichen Ohrs entsprechen sollten. Spektralwerte in einer Skalenfaktorgruppe werden mit einem Skalenfaktor multipliziert, um Spektralwerte eines Skalenfaktorbandes insgesamt zu skalieren. Die durch den Skalenfaktor skalierten Skalenfaktorbänder werden anschließend quantisiert, woraufhin quantisierte Spektralwerte entstehen. Selbstverständlich ist eine Gruppierung in Skalenfaktorbänder nicht entscheidend. Sie wird jedoch bei den Standards MPEG-Layer 3 bzw. bei dem Standard MPEG-2 AAC (AAC = Advanced Audio Coding) verwendet.

Ein sehr wesentlicher Aspekt der Datenreduzierung besteht in der nach dem Quantisieren folgenden Entropie-Codierung der quantisierten Spektralwerte. Für die Entropiecodierung wird üblicherweise eine Huffman-Codierung verwendet. Unter einer Huffman-Codierung versteht man eine Codierung mit variabler Länge, d. h. die Länge des Codeworts für einen zu codierenden Wert ist abhängig von dessen Auftrittswahrscheinlichkeit. Logischerweise ordnet man dem wahrscheinlichsten Zeichen den kürzesten Code, d. h. das kürzeste Codewort, zu, so daß mit der Huffman-Codierung eine sehr gute Redundanzreduktion erreicht werden kann. Ein Beispiel für eine allseits bekannte Codierung mit variabler Länge ist das Morse-Alphabet.

In der Audiocodierung werden Huffman-Codes zur Codierung der quantisierten Spektralwerte benutzt. Ein moderner Audio-Coder, der beispielsweise nach dem Standard MPEG-2 AAC arbeitet, verwendet zur Codierung der quantisierten Spektralwerte verschiedene Huffman-Codetabellen, die dem Spektrum nach bestimmten Kriterien abschnittsweise zugeordnet werden. Dabei werden immer 2 oder 4 Spektralwerte in einem Codewort gemeinsam codiert.

Ein Unterschied des Verfahrens nach MPEG-2 AAC gegenüber dem Verfahren MPEG-Layer 3 besteht nun darin, daß verschiedene Skalenfaktorbänder, d. h. verschiedene Spektralwerte, zu beliebig vielen Spektralabschnitten oder "Sections" gruppiert werden. Bei AAC umfaßt ein Spektralabschnitt oder eine "Section" zumindest vier Spektralwerte aber vorzugsweise mehr als vier Spektralwerte. Der gesamte Frequenzbereich der Spektralwerte wird daher in benachbarte Sections aufgeteilt, wobei eine Section ein Frequenzband darstellt, derart, daß alle Sections zusammen den gesamten Frequenzbereich, der durch die Spektralwerte nach der Transformation derselben überdeckt wird, umfassen.

Einem Abschnitt wird nun ebenso wie beim MPEG-Layer-3-Verfahren zum Erreichen einer maximalen Redundanzreduktion eine sog. Huffman Tabelle aus einer Mehrzahl derartiger Tabellen zugeordnet. Im Bitstrom des AAC-Verfahrens, welches üblicherweise 1024 Spektralwerte aufweist, befinden sich nun die Huffman-Codewörter für die Spektralwerte in aufsteigender Frequenzreihenfolge. Die Information über die in jedem Frequenzabschnitt verwendete Tabelle wird in den Seiteninformationen übertragen.

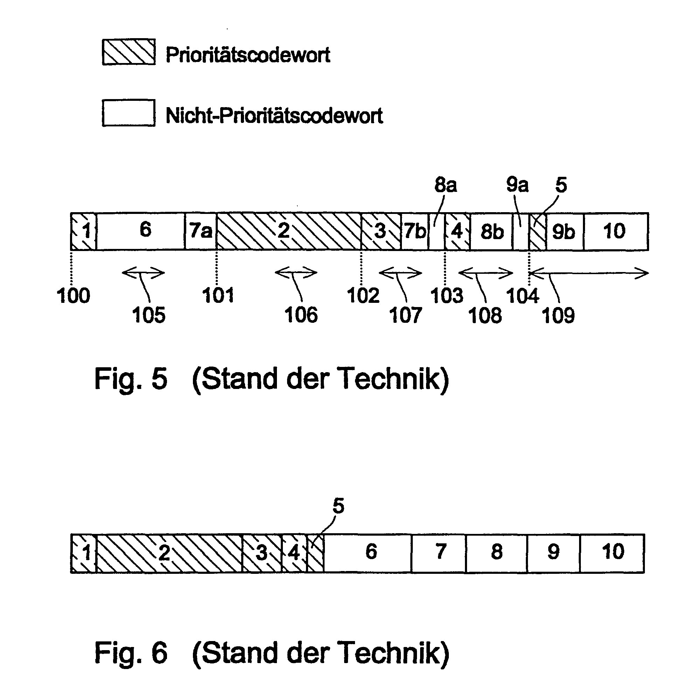

Fig. 6 stellt den beispielhaften Fall dar, bei dem der Bitstrom 10 Huffman-Codeworte umfaßt. Wenn immer aus einem Spektralwert ein Codewort gebildet wird, so können hier 10 Spektralwerte codiert sein. Üblicherweise werden jedoch immer 2 oder 4 Spektralwerte durch ein Codewort gemeinsam codiert, weshalb Fig. 6 einen Teil des codierten Bitstroms darstellt, der 20 bzw. 40 Spektralwerte umfaßt. In dem Fall, in dem jedes Huffman-Codewort 2 Spektralwerte umfaßt, stellt das mit der Nr. 1 bezeichnete Codewort die ersten 2 Spektralwerte dar, wobei die Länge des Codeworts Nr. 1 relativ klein ist, was bedeutet, daß die Werte der beiden ersten Spektralwerte, d. h. der beiden niedrigsten Frequenzkoeffizienten, relativ häufig auftreten. Das Codewort mit der Nr. 2 hingegen besitzt eine relativ große Länge, was bedeutet, daß die Beträge des 3. und 4. Spektralkoeffizienten im codierten Audiosignal relativ selten sind, weshalb dieselben mit einer relativ großen Bitmenge codiert werden. Aus Fig. 6 ist ferner ersichtlich, daß die Codewörter mit den Nr. 3, 4 und 5, die die Spektralkoeffizienten 5 und 6, bzw. 7 und 8 bzw. 9 und 10 darstellen, ebenfalls relativ häufig auftreten, da die Länge der einzelnen Codewörter relativ gering ist. Ähnliches gilt für die Codewörter mit den Nr. 6 - 10.

Wie es bereits erwähnt wurde, ist es aus Fig. 6 deutlich ersichtlich, daß die Huffman-Codewörter für die codierten Spektralwerte bezüglich der Frequenz linear ansteigend im Bitstrom angeordnet sind, wenn ein Bitstrom betrachtet wird, der durch eine bekannte Codiervorrichtung erzeugt wird.

Ein großer Nachteil von Huffman-Codes im Falle fehlerbehafteter Kanäle ist die Fehlerfortplanzung. Es sei beispielsweise angenommen, daß das Codewort Nr. 2 in Fig. 6 gestört ist. Mit einer gewissen nicht niedrigen Wahrscheinlichkeit ist dann auch die Länge dieses falschen Codeworts Nr. 2 verändert. Dieselbe unterscheidet sich somit von der richtigen Länge. Wenn im Beispiel von Fig. 6 das Codewort Nr. 2 bezüglich seiner Länge durch eine Störung verändert worden ist, ist es für einen Codierer nicht mehr möglich, die Anfänge der Codewörter 3 - 10, d. h. fast des gesamten dargestellten Audiosignals, zu bestimmen. Es können also auch alle anderen Codewörter nach dem gestörten Codewort nicht mehr richtig decodiert werden, da nicht bekannt ist, wo diese Codewörter beginnen, und da ein falscher Startpunkt aufgrund des Fehlers gewählt wurde.

Das europäische Patent Nr. 0612156 schlägt als Lösung für das Problem der Fehlerfortpflanzung vor, einen Teil der Codewörter variabler Länge in einem Raster anzuordnen, und die restlichen Codewörter in die verbleibenden Lücken zu verteilen, so daß ohne vollständige Decodierung oder bei fehlerhafter Übertragung der Anfang eines im Raster angeordneten Codeworts leichter gefunden werden kann.

Das bekannte Verfahren schafft für die Fehlerfortpflanzung zwar eine teilweise Abhilfe durch Umsortierung der Codewörter. Für manche Codewörter wird ein fester Platz im Bitstrom vereinbart, während für die restlichen Codewörter die verbleibenden Zwischenräume zur Verfügung stehen. Dies kostet keine zusätzlichen Bits, verhindert aber im Fehlerfall die Fehlerfortpflanzung unter den umsortierten Codewörtern.

Die deutsche Patentanmeldung 19747119.6-31, die nach dem Anmeldetag der vorliegenden Anmeldung veröffentlicht wird, schlägt vor, nicht nur irgendwelche Codeworte an Rasterpunkten anzuordnen, sondern psychoakustisch bedeutsame Codeworte, d. h. Codeworte für Spektralwerte, die einen bedeutsamen Beitrag zum Audiosignal liefern, an Rasterpunkten anzuordnen. Ein Datenstrom mit Codeworten variabler Länge, wie er von einem solchen Codierer erzeugt wird, ist in Fig. 5 gezeigt. Der Datenstrom umfaßt ebenfalls wie in Fig. 6 10 Codeworte, wobei die Prioritätscodeworte schraffiert sind. Das erste Prioritätscodewort ist an einem ersten Rasterpunkt 100 beginnend angeordnet, das zweite Prioritätscodewort ist an einem zweiten Rasterpunkt 101 beginnend angeordnet, das dritte Prioritätscodewort ist an einem dritten Rasterpunkt 102 beginnend angeordnet, das vierte Prioritätscodewort ist an einem vierten Rasterpunkt 103 beginnend angeordnet, und das fünfte Prioritätscodewort ist an einem fünften Rasterpunkt 104 beginnend angeordnet. Durch die Rasterpunkte 100 und 101 ist ein erstes Segment 105 definiert. Auf ähnliche Art und Weise ist ein zweites 106, ein drittes 107, ein viertes 108 und ein Abschlußsegment 109 definiert. In Fig. 5 ist gezeigt, daß die ersten beiden Segmente 105 und 106 eine andere Länge als die beiden Segmente 107 und 108 und wieder eine andere Länge als das Schlußsegment 109 haben. Die Nicht-Prioritätscodeworte 6, 7, 8, 9 und 10 werden an die Prioritätscodeworte anschließend in den Datenstrom eingetragen, derart, daß derselbe gewissermaßen aufgefüllt wird. Wie es in Fig. 5 gezeigt ist, werden bei dem nachveröffentlichten Verfahren die Nicht-Prioritätscodeworte fortlaufend in das Raster eingefügt, nachdem die Prioritätscodeworte geschrieben worden sind. Im einzelnen wird das Nicht-Prioritätscodewort Nr. 6 an das Nicht-Prioritätscodewort 1 anschließend eingetragen. Der dann noch in dem Segment 105 verbleibende Platz wird mit den anschließenden Nicht-Prioritätscodewort 7 aufgefüllt, wobei der Rest des Nicht-Prioritätscodeworts 7, d. h. 7b, in den nächsten freien Platz, d. h. in das Segment 107 direkt an das Prioritätscodewort 3 anschließend geschrieben wird. Entsprechend wird mit den Nicht-Prioritätscodeworten 8 bis 10 verfahren.

Das in Fig. 5 dargestellte nachveröffentlichte Verfahren hat den Vorteil, daß die Prioritätscodeworte 1 bis 5 vor einer Fehlerfortpflanzung geschützt sind, da ihre Anfangspunkte mit Rasterpunkten zusammenfallen und damit bekannt sind.

Ist nun beispielsweise das Prioritätscodewort 2 bei der Übertragung beschädigt worden, so wird bei dem in Fig. 6 gezeigten Stand der Technik ein Decodierer sehr wahrscheinlich keines der restlichen Codeworte 3 bis 10 mehr korrekt decodieren können. Bei dem in Fig. 5 gezeigten Verfahren fängt jedoch das nächste Codewort, d. h. das Prioritätscodewort 3, an dem Rasterpunkt 102 an, derart, daß der Decodierer auf jeden Fall den korrekten Anfang des Codeworts 3 finden wird. Somit wird bei dem in Fig. 5 gezeigten Verfahren überhaupt kein Folgefehler auftreten, und es wird nur das Prioritätscodewort Nr. 2 beschädigt sein. Dieses Verfahren somit einen effektiven Schutz für Prioritätscodewerte, die an Rasterpunkten angeordnet sind.

Es besteht jedoch kein effektiver Schutz für Nicht-Prioritätscodeworte. Bezugnehmend auf Fig. 5 wird eine Beschädigung des Nicht-Prioritätscodeworts Nr. 6, derart, daß der Decodierer als falsches Codewort Nr. 6 eine um ein Bit kürzeres Codewort annimmt, dazu führen, daß auch das Codewort 7 nicht mehr korrekt decodiert werden kann, da das letzte Bit des korrekten Codeworts Nr. 6 bereits als Anfang des nächsten Codeworts Nr. 7 interpretiert wird. Somit wird ein Fehler im Codewort Nr. 6 dazu führen, daß sehr wahrscheinlich sämtliche daran anschließende Codeworte aufgrund eines Folgefehlers nicht mehr korrekt decodiert werden können, selbst wenn sie nicht durch einen Übertragungsfehler beeinträchtigt worden sind.

Die DE 691 26 565 T2 bezieht sich auf ein Verfahren zum Übertragen von Codes variabler Länge. Durch dieses Verfahren wird ein Datenstrom erzeugt, in dem ausgehend vom Anfang des Datenstroms Codewörter variabler Länge in einer ersten Richtung bis zu einem bestimmten Punkt im Datenstrom geschrieben werden. Zur Erhöhung der Fehlerrobustheit wird jedoch nicht der gesamte Datenstrom in einer Richtung geschrieben, sondern lediglich bis zu dem vorbestimmten Punkt. Vom Ende des Datenstroms aus wird dann in entgegengesetzter Schreibrichtung der Rest der Codewörter variabler Länge bis zu dem vorbestimmten Punkt geschrieben, so daß sich ein Datenstrom ergibt, dessen erste Hälfte Codewörter aufweist, die in Vorwärtsrichtung geschrieben sind, und dessen zweite Hälfte Codewörter aufweist, die in Rückwärtsrichtung geschrieben sind.

Das US-Patent Nr. 5,852,469 bezieht sich auf Codier- und Decodiersysteme für Codewörter mit variabler Länge und Codewörter mit fester Länge. Für Codewörter mit fester Länge ist vorgesehen, im Datenstrom Synchronstellen vorzusehen, deren Abstand gleich der Länge der Codewörter fester Länge ist. Die Codewörter werden dann derart in den Datenstrom eingetragen, daß sie alle an einer Synchronstelle beginnen. Für Codewörter variabler Länge wird ein Datenstrom mit einem Anfang und einem Ende, jedoch ohne Synchronstellen, vorgesehen, um ausgehend vom Anfang des Datenstroms bis zu einer bestimmten Stelle hinter der Mitte des Datenstroms Codewörter variabler Länge in der Vorwärtsrichtung einzutragen. Vom Ende des Datenstroms bis zu der vorbestimmten Stelle in der Mitte werden dann Codewörter variabler Länge in der entgegengesetzten Schreibrichtung eingetragen.

Die Aufgabe der vorliegenden Erfindung besteht darin, Datenströme aus Codeworten variabler Länge fehlerrobuster zu machen.

Diese Aufgabe wird durch eine Vorrichtung zum Erzeugen eines Datenstroms nach Patentanspruch 1, durch eine Vorrichtung zum Lesen eines Datenstroms nach Patentanspruch 9, durch ein Verfahren zum Erzeugen eines Datenstroms nach Patentanspruch 14 und durch ein Verfahren zum Lesen eines Datenstroms nach Patentanspruch 15 gelöst.

Der vorliegenden Erfindung liegt die Erkenntnis zugrunde, daß die Robustheit eines Datenstroms gegenüber Übertragungsfehlern, und insbesondere gegenüber Folgefehlern bei Codeworten variabler Länge entscheidend erhöht werden kann, wenn der Datenstrom nicht nur in einer Schreibrichtung geschrieben wird, sondern zusätzlich in der anderen Schreibrichtung. Im allgemeinsten Fall wird ein Datenstrom immer einen Anfang und ein Ende haben. Im Stand der Technik wurde der Datenstrom im einfachsten Fall ausgehend vom Anfangspunkt beschrieben, bis er zu Ende war. Dadurch konnte ein Übertragungsfehler im ersten Codewort dazu führen, daß der gesamte Datenstrom nicht mehr korrekt decodiert werden konnte, selbst wenn sämtliche anderen Codeworte korrekt übertragen wurden. Erfindungsgemäß könnte ein solcher Datenstrom derart geschrieben werden, daß die erste Hälfte des Datenstroms ausgehend vom Anfang des Datenstroms geschrieben wird, während die zweite Hälfte des Datenstroms ausgehend vom Ende des Datenstroms geschrieben wird. Bereits aus diesem einfachen Beispiel ist zu sehen, daß ein Übertragungsfehler in der erste Hälfte des Datenstroms nicht mehr dazu führt, daß auch Codeworte des zweiten Datenstroms aufgrund von Folgefehlern nicht mehr korrekt decodiert werden können. Dies ist der Fall, da ein Decodierer weiß, daß er nach der Hälfte des Datenstroms vom Ende des Datenstroms aus weiter lesen muß, und zwar in der entgegengesetzten Leserichtung. Damit wird lediglich aufgrund der Umkehrung der Schreibrichtung/Leserichtung praktisch ohne Mehraufwand eine gewisse Fehlerrobustheit erreicht.

Wie es bereits erwähnt worden ist, werden Codeworte mit variabler Länge unter Verwendung von Rasterpunkten in einen Datenstrom geschrieben, derart, daß ein Decodierer mit einer begrenzten Anzahl von Folgefehlern decodieren kann, da per Definition bestimmte Codeworte an Rasterpunkten beginnen. Zur maximalen Fehlerrobustheit wird prinzipiell ein möglichst enges Raster erwünscht sein, derart, daß ein Decodierer die korrekten Anfangspunkte möglichst vieler Codeworte finden kann. Andererseits führt eine Erhöhung der Anzahl der Rasterpunkte, d. h. eine Verkleinerung der Segmentlänge, dazu, daß immer weniger Codeworte, die ja variable Längen haben, vollständig in das Raster passen, weshalb Vorkehrungen getroffen werden, daß die Endabschnitte derselben in andere Segmente geschrieben werden, um beim Decodieren korrekt erfaßt werden zu können. Dies führt zu einem steigenden Mehraufwand mit steigender Anzahl von Rasterpunkten bzw. mit kleiner werdender Segmentlänge.

Im Stand der Technik wurden Codeworte ausgehend von einem Rasterpunkt in nur einer einzigen Schreibrichtung geschrieben, wie es bezugnehmend auf die Fig. 5 und 6 erläutert worden ist. Erfindungsgemäß werden nun Codeworte ausgehend von Rasterpunkten auch in der umgekehrten Schreibrichtung geschrieben, wodurch die Anzahl der Codeworte, die an Rasterpunkten beginnend geschrieben werden können, im wesentlichen ohne zusätzlichen Mehraufwand im günstigsten Fall verdoppelt wird. Das Schreiben des Datenstroms mittels einer Einrichtung zum Schreiben in einer ersten Schreibrichtung von einem Bezugspunkt aus mittels einer zweiten Einrichtung zum Schreiben in einer zu der ersten Schreibrichtung entgegengesetzten zweiten Schreibrichtung von einem anderen Bezugspunkt aus wird es möglich, nicht nur "eine Seite" eines Bezugspunkts, sondern beide Seiten eines Bezugspunkts für die Fehlerrobustheit, d. h. für eine Sicherung gegen Fortpflanzungs- oder Folgefehler, auszunutzen. Je nach Ausführungsform kann beispielsweise jedes zweite Codewort in der gleichen Richtung geschrieben werden, und jedes verbleibende Codewort in der anderen Richtung. Andererseits können die Codeworte variabler Länge in verschiedene Sätze von Codeworten beispielsweise entsprechend ihrer Priorität, eingeteilt werden, derart, daß beispielsweise sämtliche Codeworte des ersten Satzes beginnend an Rasterpunkten in der ersten Schreibrichtung geschrieben werden und sämtliche Codeworte des zweiten Satzes beginnend an Rasterpunkten in der zweiten Schreibrichtung geschrieben werden können.

Darüberhinaus können Reste von Codeworten in derselben Schreibrichtung wie die Anfangsabschnitte der Codeworte geschrieben werden, oder aber auch in der umgekehrten Schreibrichtung. Selbstverständlich müssen Vorkehrungen getroffen werden, daß ein Decodierer, d. h. eine Vorrichtung zum Lesen des Datenstroms, immer genau im Bilde ist, welche Schreibrichtung beim Schreiben verwendet worden ist. Dies könnte entweder fest eingestellt werden, oder aber als Seiteninformationen zu dem Datenstrom aus Codeworten variabler Länge übertragen werden. Dasselbe trifft auch für die Segmentlängen zu, wobei die Segmentlänge entweder über dem gesamten Datenstrom gleich sein kann oder variieren kann, wobei die aktuelle Segmentlänge selbstverständlich ebenfalls in einem Decodierer fest eingestellt sein kann oder über Seiteninformationen zusammen mit den Codeworten variabler Länge übertragen werden kann.

Bevorzugte Ausführungsbeispiele der vorliegenden Erfindung werden nachfolgend bezugnehmend auf die beiliegenden Zeichnungen detailliert erläutert. Es zeigen:
- Fig. 1: eine erfindungsgemäße Vorrichtung zum Schreiben eines fehlerrobusten Datenstroms;
- Fig. 2: eine erfindungsgemäße Vorrichtung zum Lesen eines fehlerrobusten Datenstroms;
- Fig. 3: ein Verfahrensablaufdiagramm des erfindungsgemäßen Verfahrens anhand von drei Sätzen von Codeworten variabler Länge;
- Fig. 4: ein Verfahrensablaufdiagramm zur Veranschaulichung des erfindungsgemäßen Verfahrens zum Lesen eines Datenstroms, der gemäß Fig. 3 erzeugt worden ist;
- Fig. 5: ein Datenstrom, der durch eine bekannte Vorrichtung erzeugt wird, bei dem die Prioritätscodeworte einer Fehlerfortpflanzung ausgesetzt sind; und
- Fig. 6: ein Datenstrom, bei dem eine Sortierung in Prioritätscodeworte und Nicht-Prioritätscodeworte durchgeführt ist.

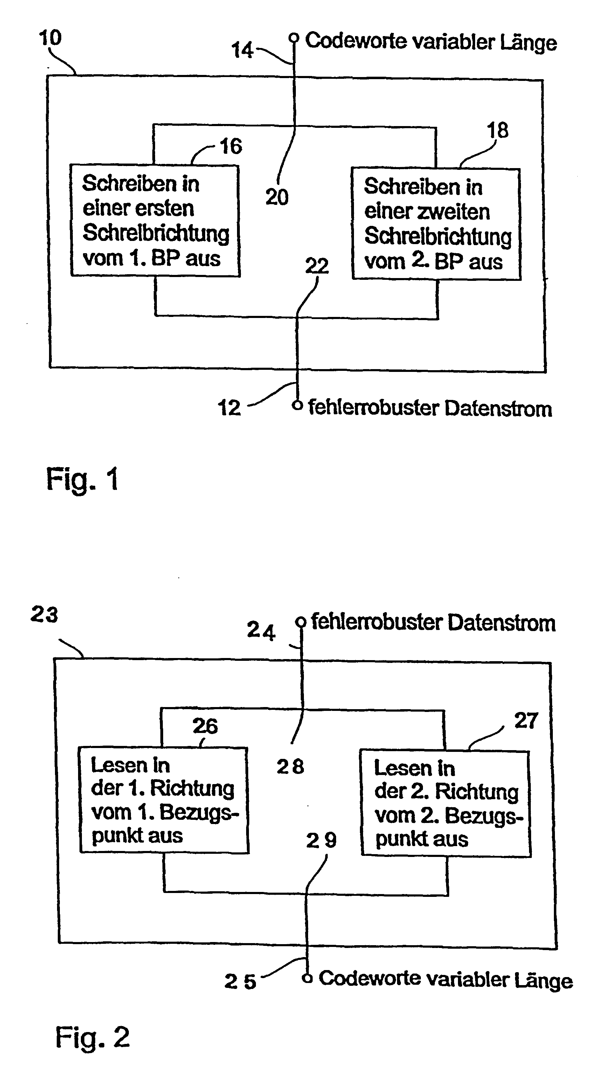

Bevor auf Fig. 1 näher eingegangen wird, sei angemerkt, daß eine Codierung mit Codeworten variabler Länge in der Technik auch als Entropie-Codierung bezeichnet wird. Ein Vertreter der Entropie-Codierung ist die sogenannte Huffman-Codierung. Prinzipiell werden bei der Huffman-Codierung die zu codierenden Informationssymbole statistisch untersucht, um für die Informationssymbole, die häufiger auftreten, kürzere Codeworte zu bestimmen als für Informationssymbole, die weniger häufig auftreten. Bei einem vollständigen Huffman-Code sind sämtliche Codeworte abgeschlossene Enden oder Zweige eines Codebaums. Ein Huffman-Decodierer liest einen Datenstrom mit Huffman-Codeworten beispielsweise seriell ein und springt anschaulich gesprochen mit jedem Bit, das er zusätzlich einliest, zu einer Verzweigung des festgelegten Codebaums, bis er nach einer bestimmten Anzahl von Sprüngen, die der Anzahl von Bits des Codeworts, d. h. der Länge des Codeworts, entspricht, an einem Zweigende ankommt, das keine weitere Verzweigung aufweist, und somit ein Codewort ist. Dann weiß der Decodierer, daß mit dem nächsten Bit ein neues Codewort beginnt. Dieses Verfahren wird so oft wiederholt, bis der Datenstrom vollständig eingelesen ist. Mit jedem Mal, zu dem der Huffman-Codierer wieder an den Anfangspunkt, d. h. die Wurzel des Baumes zurückspringt, liegt an seinem Ausgangspunkt ein Codewort vor. Da die Länge der Codeworte implizit durch die Codeworte selbst bzw. durch den im Codierer und im Decodierer bekannten Codebaum gegeben ist, ist zu sehen, daß eine Störung im Datenstrom, die zu einer Umkehrung eines Bits führt, den Decodierer in dem Codebaum gewissermaßen irreführt, derart, daß er zu einem anderen Codewort, d. h. einem falschen Codewort, gelangt, das sehr wahrscheinlich eine andere Länge hat als das richtige Codewort. In diesem Fall wird der Decodierer, wenn er an dem falschen Codewort angelangt ist, wieder zurückspringen und aufgrund der dann folgenden Bits wieder von Verzweigungspunkt zu Verzweigungspunkt in dem Codebaum laufen. Der Decodierer hat jedoch keine Möglichkeit, einen Folgefehler zu vermeiden, es sei denn, daß er zufällig wieder auf die "richtige Spur" kommt.

Daher müssen für eine fehlerrobuste Übertragung Fehlersicherungen unternommen werden, wie sie die vorliegende Erfindung vorsieht. Die Vorrichtung zum Erzeugen eines Datenstroms aus Codeworten variabler Länge gemäß der vorliegenden Erfindung könnte daher gewissermaßen als Sende- oder Ausgangsstufe eines Huffman-Codierers fungieren, während die Vorrichtung zum Lesen eines Datenstroms aus Codeworten variabler Länge als Empfangs- bzw. Eingangsstufe eines Huffman-Decodierers wirken könnte. Daraus ist jedoch zu sehen, daß die vorliegende Erfindung nicht nur auf Huffman-Codierer anwendbar ist, sondern auf jeglichen Code mit Codeworten variabler Länge, der für Folgefehler anfällig ist.

Fig. 1 zeigt eine erfindungsgemäße Vorrichtung 10 zum Erzeugen eines fehlerrobusten Datenstroms an einem Ausgang 12, wenn Codeworte variabler Länge an einem Eingang 14 in die Vorrichtung 10 eingegeben werden. Die Vorrichtung umfaßt eine erste Einrichtung 16 zum Schreiben in einer ersten Schreibrichtung von einem ersten Bezugspunkt aus und eine zweite Einrichtung 18 zum Schreiben in einer zweiten Schreibrichtung von einem zweiten Bezugspunkt aus. Je nach Komplexität der Vorrichtung 10 können die Codeworte variabler Länge beide an die beiden Einrichtungen 16 und 18 zum Schreiben angelegt werden, wie es in Figur 1 durch einen einfachen Verzweigungspunkt 20 und einen entsprechenden Kombinationspunkt 22 dargestellt ist. Die Auswahl, welche Codeworte in welcher Richtung geschrieben werden, bzw. welche Abschnitte von Codeworten in welcher Richtung geschrieben werden, würde dann durch die Einrichtungen 16 und 18 durchgeführt werden. Alternativ könnte statt dem Knoten 20 ein Demultiplexer vorhanden sein, der bestimmte Codeworte, beispielsweise Codeworte eines Satzes von Codeworten, der ersten Einrichtung 16 zuführt und bestimmte Codeworte der zweiten Einrichtung 18 zuführt. In Analogie dazu würde der Kombinationspunkt 22 dann durch einen Multiplexer ausgeführt sein, der den fehlerrobusten Datenstrom 12 multiplext. Andere entsprechend gesteuerte Einrichtungen zum Speisen der beiden Einrichtungen 16 und 18 mit den Codeworten variabler Länge sind für Fachleute im Lichte der vorliegenden Beschreibung offensichtlich.

Eine zur Vorrichtung 10 zum Erzeugen eines Datenstroms, die in Fig. 1 gezeigt ist, komplementäre Vorrichtung 23 zum Lesen eines fehlerrobusten Datenstroms ist in Fig. 2 gezeigt. Dieselbe umfaßt einen Eingang 24, in dem der fehlerrobuste Datenstrom nach einer Übertragung beispielsweise über eine Funkstrecke, eingegeben wird um an einem Ausgangspunkt 25 wieder die Codeworte variabler Länge zu erhalten, die in den Eingang 14 der Vorrichtung 10 aus Fig. 1 eingespeist worden sind. Die Vorrichtung 23 zum Lesen des Datenstroms umfaßt eine erste Einrichtung 26 zum Lesen in der ersten Richtung von dem ersten Bezugspunkt aus und eine zweite Einrichtung 27 zum Lesen des Datenstroms in der zweiten Richtung von einem zweiten Bezugspunkt aus.

Die Vorrichtung 23 enthält selbstverständlich ebenfalls einen Verzweigungspunkt 28 und einen Kombinationspunkt 29, wobei die Einspeisung des fehlerrobusten Datenstroms in die beiden Einrichtungen 26 und 27 beispielsweise basierend auf einem festeingestellten Algorithmus stattfindet oder basierend auf Seiteninformationen, die zusammen mit dem fehlerrobusten Datenstrom ebenfalls von dem Sender d. h. der Vorrichtungen 10 in Fig. 1, zu dem Empfänger, d. h. der Vorrichtung 23 in Fig. 2 übertragen werden können.

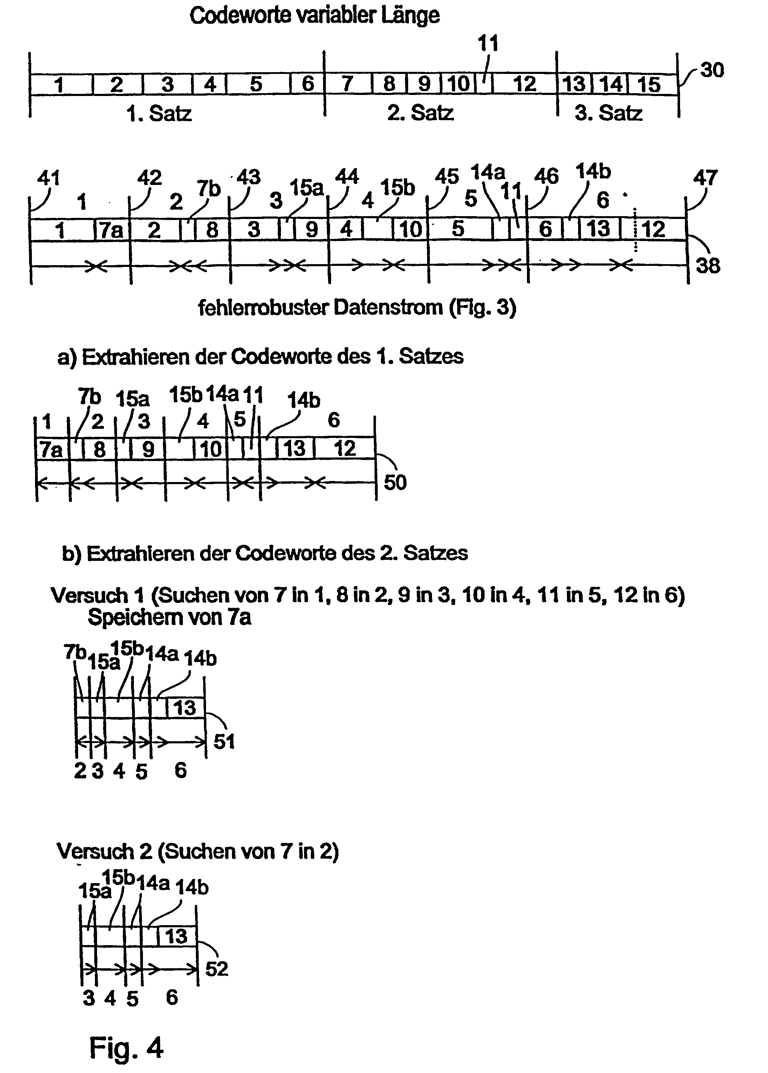

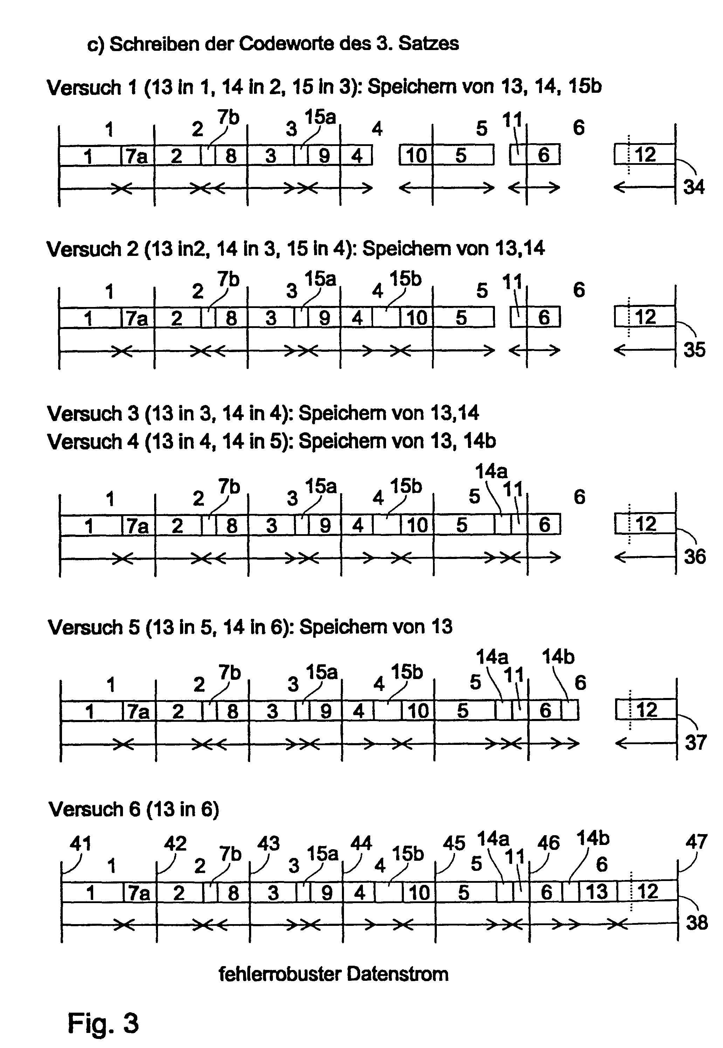

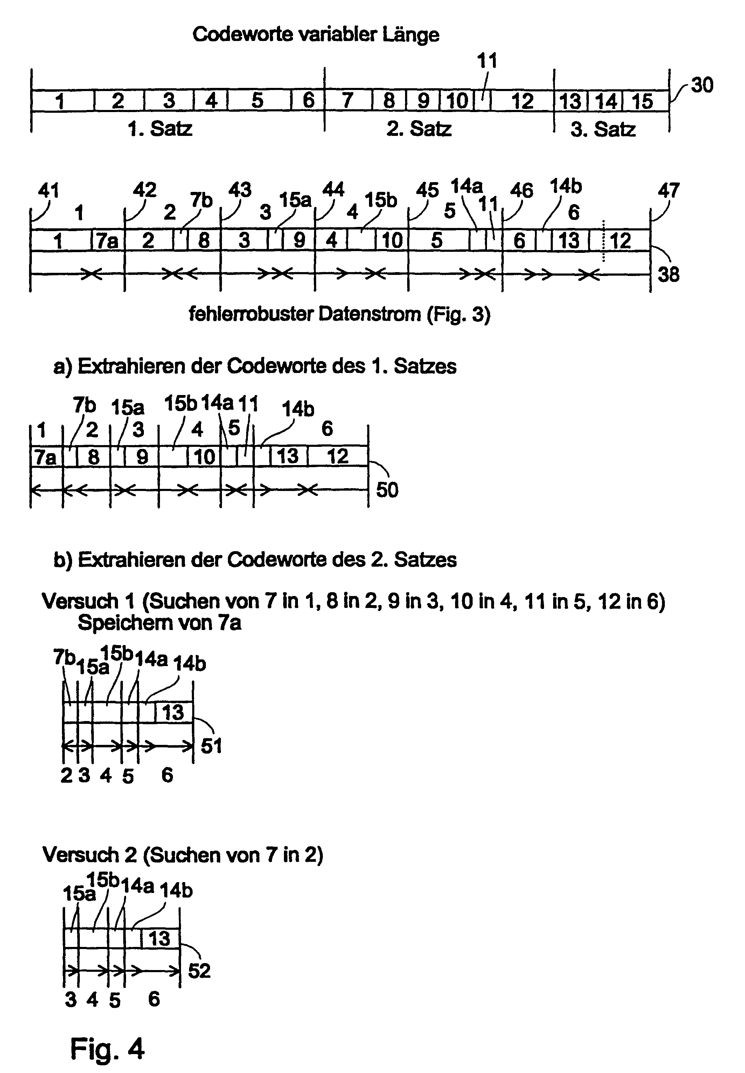

In Fig. 3 ist anhand eines Beispiels das erfindungsgemäße Verfahren zum Schreiben von Codeworten variabler Länge dargestellt. Im Beispiel existieren 15 Codeworte variabler Länge 30, die vorzugsweise in einen ersten Satz mit 6 Codeworten 1 bis 6, in einen zweiten Satz mit ebenfalls 6 Codeworten 7 bis 12 und in einen dritten Satz mit den restlichen 3 Codeworten 13 bis 15 aufgeteilt sind. Wie es in Fig. 3 gezeigt ist, haben die Codeworte 30 variable Längen.

Gemäß einem bevorzugten Ausführungsbeispiel der vorliegenden Erfindung ist die Segmentlänge, d. h. die Länge eines Segments, größer als die Länge des längsten Codeworts des ersten Satzes. Die Codeworte des ersten Satzes werden an Rasterpunkten 41 bis 46 angeordnet, wobei für das letzte Segment Nr. 6 ein Rasterpunkt gestrichelt angedeutet ist, der jedoch nicht verwendet wird, da das Ende 47 des Datenstroms gewissermaßen ebenfalls als Rasterpunkt angesehen werden kann und der gestrichelt angedeutete Rasterpunkt somit überflüssig ist. Das letzte Segment Nr. 6 ist daher länger als die anderen Segmente, was für die vorliegende Erfindung jedoch völlig unerheblich ist. Die Segmente können allgemein gesagt beliebige Längen haben, die sich innerhalb des Datenstroms ändern, wobei jedoch die aktuelle Länge eines Segments selbstverständlich dem Decodierer bekannt sein muß, damit die erfindungsgemäßen Vorteile genutzt werden können.

Zunächst werden in einem Schritt a) die Codeworte des ersten Satzes in den Datenstrom geschrieben, woraus sich ein mit 31 bezeichneter bruchstückhafter Datenstrom ergibt, bei dem die Codeworte des ersten Satzes von links nach rechts in ein jeweiliges Segment geschrieben werden, wie es durch Pfeile 48 angedeutet ist, die in der gesamten Fig. 3 die Schreibrichtung symbolisieren sollen. Da die Segmentlänge länger als die größte Länge eines Codeworts des ersten Satzes gewählt ist, wird für den Schritt a) lediglich ein einziger Versuch benötigt. Ist die Segmentlänge kürzer, können entsprechend mehr Versuche erforderlich sein.

In einem Schritt b) werden nun die Codeworte des zweiten Satzes in den Datenstrom 31 geschrieben. Um eine hohe Fehlerrobustheit zu erreichen, werden die Codeworte des zweiten Satzes nicht von links nach rechts wie die Codeworte des ersten Satzes geschrieben, sondern jeweils ausgehend von dem zweiten Rasterpunkt z.B. dem Rasterpunkt 42 für das erste Segment, von rechts nach links geschrieben, wie es durch den entsprechenden Schreibrichtungspfeil angedeutet ist. Das Schreiben der Codeworte des zweiten Satzes findet nach einer vorbestimmten Zuordnungsvorschrift statt, die bei dem gewählten Beispiel derart lautet, daß das erste Codewort des zweiten Satzes in dem gleichen Segment geschrieben werden soll wie das erste Codewort des ersten Satzes, jedoch immer unter der Voraussetzung, daß in diesem Segment noch Platz ist. Der aus dem ersten Versuch entstandene Datenstrom 32 zeigt, daß im ersten Segment lediglich soviel Platz war, den Anfangsabschnitt des Codeworts Nr. 7 zu schreiben.

Im Gegensatz zum Stand der Technik, bei dem der zweite Teil des Codeworts Nr. 7 in das zweite Segment geschrieben worden wäre, wird die zweite Hälfte des Codeworts Nr. 7, d. h. 7b, gespeichert, um dasselbe nach einer vorbestimmten Vorschrift, d. h. nach einer Vorschrift die auch dem Decodierer bekannt sein muß, in einem zweiten Versuch in den Datenstrom zu schreiben. Fig. 3 macht deutlich, daß in dem zweiten Segment zwischen dem Codewort Nr. 2 und 8 noch soviel Platz vorhanden war, daß der Endabschnitt des Codeworts Nr. 7 eingetragen werden konnte. Wäre nicht genug Platz gewesen, so wäre der dritte Abschnitt des Codeworts in das Segment Nr. 3 eingetragen worden. Die vorbestimmte Vorschrift zum Eintragen des Codeworts Nr. 7 in den Datenstrom besteht bei Fig. 3 also darin, immer um ein Segment weiter zu gehen. Selbstverständlich könnte auch immer um zwei Segmente weitergegangen werden, oder um drei oder mehr, derart, daß dann der zweite Abschnitt 7b statt in das zweite Segment in das dritte, im nächsten Versuch in das fünfte etc. geschrieben werden könnte. Die Reihenfolge der Segmente, die verwendet wird, um den zweiten Teil des Abschnitt 7 irgendwo unterzubringen, ist beliebig. Sie muß jedoch dem Decodierer transparent sein, damit der umsortierte Datenstrom wieder gelesen werden kann.

In den entstandenen ebenfalls noch bruchstückhaften Datenstrom 33 sollen nun die Codeworte des dritten Satzes 13 bis 15 eingetragen werden. In Analogie zu dem Schritt b) geschieht dies vorzugsweise anhand der selben zuordnungsvorschrift, derart, daß das erste Codewort des dritten Satzes dem ersten Segment zugeordnet ist, das zweite Codewort des dritten Satzes dem zweiten Segment zugeordnet ist, das dritte Codewort des dritten Satzes dem dritten Segment zugeordnet ist usw. Diese Zuordnungsvorschrift ist für den dritten Satz völlig beliebig und kann sich auch von der Zuordnungsvorschrift für den zweiten Satz unterscheiden, wobei erfindungsgemäß jedes Codewort eines Satzes einem anderen Segment zugeordnet ist. Genauso ist die Schreibrichtung für jeden Satz beliebig wählbar. Vorzugsweise wird eine alternierende Schreibrichtungsreihenfolge verwendet. Alternativ können jedoch auch zwei benachbarte Sätze mit der gleichen Schreibrichtung geschrieben werden. Prinzipiell kann auch die Schreibrichtung innerhalb eines Satzes verändert werden.

Der erste Versuch im Schritt c) war lediglich darin erfolgreich, den ersten Abschnitt des Codeworts Nr. 15 einzutragen, wodurch sich ein bruchstückhafter Datenstrom 34 ergeben hat. Die Codeworte 13, 14 und der zweite Abschnitt des Codeworts 15, d. h. 15b, werden gespeichert, um im zweiten, dritten, vierten, fünften und sechsten Versuch untergebracht zu werden, wobei im zweiten Versuch der zweite Abschnitt 15b im vierten Segment untergebracht werden konnte (Datenstrom 35), im dritten Versuch nichts untergebracht werden konnte, im vierten Versuch der Anfangsabschnitt des Codeworts 14 untergebracht werden konnte (Datenstrom 36), im fünften Versuch der Endabschnitt des Codeworts 14, d. h. 14b, untergebracht werden konnte (Datenstrom 37), und schließlich im sechsten und letzten Versuch das erste Codewort des dritten Satzes im sechsten Segment eingetragen werden konnte, wodurch sich der fehlerrobuste Datenstrom 38 für das hier skizzierte Beispiel ergibt. Das anhand von Fig. 3 beschriebene Verfahren stellt sicher, daß die Länge des fehlerrobusten Datenstroms genau der Summe der Längen der Codeworte variabler Länge entspricht, was im Sinne einer Entropiecodierung zur Datenreduzierung selbstverständlich ist. Die vorliegende Erfindung ist jedoch nicht darauf begrenzt, daß der fehlerrobuste Datenstrom die minimale Länge hat, da die Fehlerrobustheit nicht durch unter Umständen vorhandene Leerbits beeinträchtigt wird.

Wenn der in Fig. 3 gegebene robuste Datenstrom betrachtet wird, so ist zu sehen, daß der Anfang des Codeworts Nr. 8, d. h. der Rasterpunkt 43, völlig unabhängig von dem Ende des Codeworts Nr. 7 ist. Auch der Anfang des Codeworts Nr. 9, d. h. der Rasterpunkt 44, ist völlig unabhängig von dem Ende des Codeworts Nr. 8. Ferner sei darauf hingewiesen, daß aufgrund der entgegengesetzten Schreibreihenfolge beispielsweise ein Datenfehler im Codewort Nr. 1 im ersten Segment, der dazu führt, daß das falsche Codewort aufgrund des Datenfehlers um ein Bit kürzer als das korrekte Codewort Nr. 1 ist, nicht zu einer Zerstörung des Anfangsabschnitts des Codeworts Nr. 7a führt, da dasselbe statt von links nach rechts von rechts nach links geschrieben wurde. Wäre dasselbe von links nach rechts geschrieben worden, so würde ein Decodierer das noch übrige Bit von dem ursprünglich korrekten Codewort Nr. 1 als Anfangsbit des Codeworts Nr. 7 nehmen, wodurch sich ein Folgefehler von 1 auf 7 ergeben würde. Dieser Folgefehler würde sich jedoch nicht auf 8 fortpflanzen, da Codewort Nr. 8 wieder völlig unabhängig von Codewort Nr. 7 ist, da die Schreibreihenfolge von rechts nach links gewählt wurde. Ist die Schreibreihenfolge des Codeworts Nr. 8 gleich der Schreibreihenfolge der Codeworte des ersten Satzes, so würde sich der Fehler ebenfalls nicht von 7 auf 8 fortpflanzen, da das Codewort Nr. 8 vor dem zweiten Teil 7b aufgrund der Zuordnungsvorschrift an das Codewort Nr. 2 angrenzend geschrieben werden würde und somit nicht durch einen falschen Abschnitt 7b beeinflußt wird.

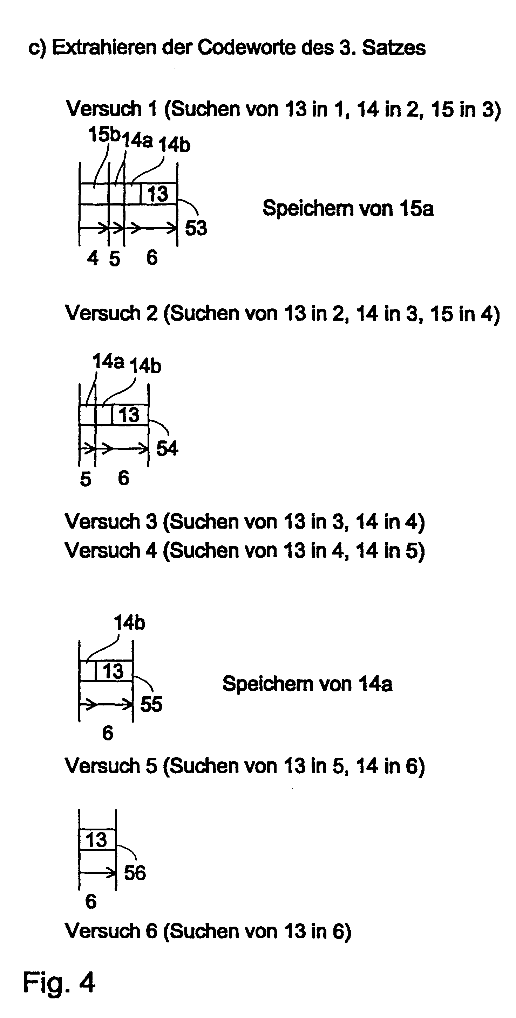

Fig. 4 zeigt anhand eines entsprechenden Beispiels die Funktionsweise der Vorrichtung zum Lesen des fehlerrobusten Datenstroms 38 auf. Zunächst werden in einem Schritt a) die Codeworte des ersten Satzes aus dem fehlerrobusten Datenstroms extrahiert. Dazu liest die erfindungsgemäße Vorrichtung, die mit einem Huffman-Decodierer gekoppelt sein dürfte, ausgehend von dem ersten Rasterpunkt 41 das Codewort des ersten Satzes, ausgehend von dem zweiten Rasterpunkt 42 das Codeworts Nr. 2 des ersten Satzes, usw. bis alle Codeworte 1 bis 6 des ersten Satzes eingelesen sind. Selbstverständlich wählt auch die Vorrichtung zum Lesen des Datenstroms die selbe Richtung, wie sie von der Vorrichtung zum Erzeugen angewendet worden ist.

Anschließend werden in einem Schritt b) aus dem noch verbleibenden Datenstrom 50 die Codeworte des zweiten Satzes extrahiert. Hierbei springt der Decodierer an den zweiten Rasterpunkt 42 des ersten Segments und erhält den Anfangsabschnitt des Codeworts 7 des zweiten Satzes (das erste Segment is jetzt leer) und liest dann nicht den zweiten Abschnitt 7b ein, sondern 7a wird zunächst gespeichert, um dann das zweite Codewort des zweiten Satzes ausgehend von dem zweiten Rasterpunkt des zweiten Segments usw. einzulesen. Es ergibt sich somit ein Restdatenstrom 51, in dem das erste Segment schon vollständig geleert ist. Da der Decodierer nun nicht das Codewort 7 durchgehend liest sondern immer segmentweise aufgrund der Vorrichtung zum Erzeugen des Datenstroms verwendeten Zuordnungsvorschrift liest, wird die bereits beschriebene Fehlerrobustheit sichergestellt, die eine Ausbreitung von Folgefehlern stark reduziert.

In einem zweiten Versuch zum Extrahieren der Codeworte des zweiten Satzes wird nun im zweiten Segment entsprechend der vorhandenen Schreibrichtung der zweite Teil des Codeworts 7b gelesen, woraufhin in dem resultierenden Datenstrom 52 nur noch Codeworte des dritten Satzes verbleiben, und das zweite Segment leer ist. Diese werden in einem Schritt c) extrahiert, wobei zunächst in einem ersten Versuch der Anfangsabschnitt des Codeworts 15 eruiert worden ist, der jedoch gespeichert wird, da das Codewort 15 nicht vollständig in dem dritten Segment aufgefunden worden ist. Das dritte Segment ist nun leer. In einem zweiten Versuch kann das Codewort 15 vollständig gefunden werden. Die Suche nach dem Codewort 14 im Segment 3 und nach dem Codewort 15 im Segment 4 blieb jedoch erfolglos, was durch den Datenstrom 54 sichtbar ist. Im vierten Versuch führte jedoch die Suche von Codewort 14 im fünften Segment zu einem positiven Ergebnis. Das Codewort 14 war jedoch nicht vollständig, weshalb der Anfangsabschnitt 14a gespeichert wurde, um dann in einem fünften Versuch den noch verbleibenden Datenstrom 55 zu untersuchen und schließlich in einem letzten sechsten Versuch den Datenstrom 56, der nur noch aus dem sechsten Segment und aus dem Codewort 13 besteht, vollständig einzulesen.

Obwohl im vorhergehenden Beispiel lediglich eine Stückelung in Anfangsabschnitt und Endabschnitt von Codeworten beispielhaft dargestellt worden ist, ist prinzipiell eine beliebige Stückelung möglich. Solange der Decodierer die Zuordnung von Codeworten des zweiten Satzes bzw. des dritten Satzes und weiterer Sätze zu jeweils unterschiedlichen Segmenten beachtet, wird eine fehlerrobuste Decodierung sichergestellt sein. Es ist ferner offensichtlich, daß die Einsortierung der Endabschnitte von Codeworten in den Datenstrom beliebig ist, solange der Decodierer bzw. die dem Decodierer vorgeschaltete Einleseschaltung genau weiß, welche vorbestimmte Vorschrift im Codierer ausgeführt worden ist.

Um noch einmal die Vorteile bzw. die Funktionsweise der vorliegenden Erfindung herauszustellen, wird auf den fehlerrobusten Datenstrom Nr. 38 von Fig. 3 verwiesen. Wenn das erste Segment zwischen den Rasterpunkten 41 und 42 betrachtet wird, so ist zu sehen, daß das Codewort Nr. 1 ausgehend von dem ersten Rasterpunkt 41 von links nach rechts geschrieben wird, wie es durch den darunter gezeichneten Pfeil deutlich ist. Der erste Teil des Codeworts Nr. 7, d. h. 7a, wird dagegen ausgehend von dem zweiten Rasterpunkt 42 von rechts nach links geschrieben. Würden beide Codeworte Nr. 1 und 7 bzw. 7a nur von links nach rechts in den Datenstrom geschrieben werden, so würde der Anfang des Codewortes 7 bzw. der Anfangspunkt des Anfangsabschnitts 7a des Codeworts 7 von dem Endpunkt des Codeworts 1 abhängen. Ein Übertragungsfehler im Codewort 1 würde damit nahezu unweigerlich auch zu einem Folgefehler im Codewort 7 führen. Wird das Codewort 7 dagegen erfindungsgemäß ausgehend von dem zweiten Rasterpunkt 42 in umgekehrter Schreibrichtung geschrieben, so hängt der Anfangspunkt des Codeworts 7 bzw. des Anfangsabschnitts 7a des Codewortes 7 nicht mehr von dem Codewort 1 ab, sondern ist durch das Raster bzw. den Rasterpunkt 42 bestimmt. Ein Decodierer wird diesen Anfangspunkt immer wissen, weshalb ein Fehler im Codewort 1 nicht zu einem Fehler im Codewort 7 führen wird. Aus dem fehlerrobusten Datenstrom 38 von Fig. 3 ist zu sehen, daß der erste Abschnitt 7a und der zweite Abschnitt 7b des Codeworts Nr. 7 beide in derselben Schreibrichtung geschrieben werden. Dies ist jedoch nicht zwingend erforderlich. Selbstverständlich könnte der zweite Abschnitt 7b des Codeworts 7 auch von links nach rechts geschrieben werden und würde dann am Ende des zweiten Codewortes Nr. 2 beginnen.

Werden die Rasterpunkte derart gewählt, daß die Segmentlängen länger sind als die höchste Länge eines Codeworts des ersten Satzes, so wird kein Segment durch das Codewort des ersten Satzes vollständig ausgefüllt, wie es beispielsweise aus dem Datenstrom 31 von Fig. 3 zu sehen ist. In diesem Fall wird die Anzahl der Codeworte, die an Rasterpunkten beginnend geschrieben werden können, tatsächlich verdoppelt, ohne einen einzigen zusätzlichen Rasterpunkt vorsehen zu müssen.

## Patentansprüche

1. Vorrichtung (10) zum Erzeugen eines Datenstroms (38), der eine Vielzahl von Rasterpunkten (41 - 47) als Bezugspunkte aufweist, wobei die Rasterpunkte ein Raster festlegen, wobei zwei benachbarte Rasterpunkte ein Segment definieren, aus Codeworten unterschiedlicher Länge, die in eine Mehrzahl von Sätzen von Codeworten aufgeteilt sind, mit folgenden Merkmalen:
einer ersten Einrichtung (16) zum Schreiben zumindest eines Teils eines jeden Codeworts eines ersten Satzes von Codeworten in den Datenstrom in einer ersten Schreibrichtung von jeweils einem ersten Rasterpunkt eines Segments aus;
einer zweiten Einrichtung (18) zum Schreiben zumindest eines Teils eines Codeworts eines zweiten Satzes von Codeworten in den Datenstrom in einer der ersten Schreibrichtung entgegengesetzten zweiten Schreibrichtung von jeweils einem zweiten Rasterpunkt eines Segments aus, wobei die Codeworte des zweiten Satzes nach einer vorbestimmten Zuordnungsvorschrift Segmenten zugeordnet sind, derart, daß jedes Codewort des zweiten Satzes einem unterschiedlichen Segment zugeordnet ist,
wobei für den Fall, daß ein Codewort (7) des zweiten Satzes nicht oder nicht vollständig in das zugeordnete Segment paßt, zumindest ein Teil dieses Codeworts oder zumindest ein Teil des Rests (7b) dieses Codeworts, der nicht in das zugeordnete Segment paßt, nach einer vorbestimmten Vorschrift in ein nicht vollbesetztes anderes Segment von der ersten Einrichtung (16) oder der zweiten Einrichtung (18) geschrieben wird, nachdem die zweite Einrichtung (18) zum Schreiben alle verbleibenden Segmente mit den anderen Codeworten des zweiten Satzes abgearbeitet hat.

2. Vorrichtung nach Anspruch 1, bei der die erste Schreibeinrichtung (16) angeordnet ist, um einen Anfangsabschnitt eines Codeworts zu schreiben, und bei der die zweite Schreibeinrichtung (18) angeordnet ist, um zumindest einen Teil des Rests des selben Codeworts zu schreiben.

3. Vorrichtung nach Anspruch 1, bei der die erste Schreibeinrichtung (16) angeordnet ist, um einen Anfangsabschnitt eines ersten Codewortes an einem ersten Rasterpunkt eines ersten Segments zu schreiben, und einen Anfangsabschnitt eines zweiten Codeworts an einem ersten Rasterpunkt eines folgenden Segments zu schreiben, und bei der die zweite Schreibeinrichtung (18) angeordnet ist, um zumindest einen Teil des Rests des ersten Codeworts von dem zweiten Rasterpunkt des zweiten Segments aus bzw. den Rest des zweiten Codewortes von dem zweiten Rasterpunkt eines weiteren Segments aus zu schreiben.

4. Vorrichtung nach Anspruch 1, bei der die zweite Schreibeinrichtung (18) angeordnet ist, um ausgehend von dem zweiten Rasterpunkt des Segments, in das die erste Schreibeinrichtung (16) geschrieben hat, zu schreiben, wobei, falls das entsprechende Codewort (7) des zweiten Satzes länger als ein freier Platz in dem Segment ist, der Teil (7a) des Codewortes des zweiten Satzes, der in den freien Platz paßt, in das Segment geschrieben wird, und der Rest (7b) zunächst gespeichert wird.

5. Vorrichtung nach einem der vorhergehenden Ansprüche, bei der die zweite Schreibeinrichtung (18) angeordnet ist, um erst dann aktiv zu werden, wenn sämtliche Codewörter des ersten Satzes in den Datenstrom geschrieben sind.

6. Vorrichtung nach Anspruch 4 oder 5, bei der die zweite Schreibeinrichtung (18) angeordnet ist, um zumindest einen Teil des Rests (7b) des Codeworts des zweiten Satzes ausgehend von dem Ende eines anderen Codeworts (8) des zweiten Satzes in den Datenstrom zu schreiben.

7. Vorrichtung nach einem der Ansprüche 1 bis 6, bei der die Codeworte in zumindest drei Sätze unterteilt sind, bei der die erste oder zweite Schreibeinrichtung (16, 18) ferner angeordnet ist, um den dritten Satz ausgehend von Enden der Codeworte des ersten bzw. zweiten Satzes zu schreiben.

8. Vorrichtung nach Anspruch 7, bei der die erste oder die zweite Schreibeinrichtung (16, 18) ferner angeordnet ist, um den dritten Satz ausgehend von Enden der Codeworte des ersten bzw. zweiten Satzes gemäß einer vorbestimmten Zuordnungsvorschrift zu schreiben, derart, daß jedes Codewort des dritten Satzes einem anderen Segment zugeordnet ist.

9. Vorrichtung (23) zum Lesen eines Datenstroms (38), der eine Vielzahl von Rasterpunkten als Bezugspunkte aufweist, wobei die Rasterpunkte ein Raster festlegen, wobei zwei benachbarte Rasterpunkte ein Segment definieren, bei der der Datenstrom eine Mehrzahl von Sätzen von Codeworten aufweist, wobei ein erster Satz von Codeworten in der ersten Richtung geschrieben ist und ein zweiter Satz von Codeworten in einer zweiten Richtung geschrieben ist, wobei die Codeworte des zweiten Satzes Segmenten des Datenstroms nach einer vorbestimmten Zuordnungsvorschrift zugeordnet sind, derart, daß jedes Codewort eines Satzes einem anderen Segment zugeordnet ist, und wobei ein Codewort des zweiten Satzes nach einer vorbestimmten Vorschrift über mehr als ein Segment aufgeteilt sein kann, mit folgenden Merkmalen:
einer ersten Einrichtung (26) zum Lesen in einer ersten Leserichtung, die der ersten Schreibrichtung entspricht;
einer zweiten Einrichtung (27) zum Lesen in einer zur ersten Leserichtung entgegengesetzten zweiten Leserichtung; und
einer Steuerungseinrichtung (28)
zum Liefern der Codeworte des ersten Satzes zu der ersten Leseeinrichtung (26), wobei jedes Codewort des ersten Satzes an dem ersten Rasterpunkt eines Segments beginnt, und
zum Liefern der Codeworte des zweiten Satzes zu der zweiten Leseeinrichtung (27), wobei gemäß der vorbestimmten Zuordnungsvorschrift zu dem zweiten Rasterpunkt eines Segments gesprungen wird, und
wobei, nachdem sämtliche Segmente nach Codeworten des zweiten Satzes durchsucht worden sind und zumindest ein Codewort des zweiten Satzes nicht vorhanden oder nicht vollständig ist, zumindest in ein weiteres Segment nach der vorbestimmten Vorschrift gesprungen wird, um das zumindest eine Codewort des zweiten Satzes vollständig oder einen Teil des zumindest einen Codeworts zu erhalten.

10. Vorrichtung nach Anspruch 9, bei der, wenn nur ein Anfangsabschnitt eines Codeworts durch eine Schreibeinrichtung in einem Segment gelesen wird, dieser Anfangsabschnitt gespeichert wird.

11. Vorrichtung nach einem der vorhergehenden Ansprüche, bei der die Codeworte Huffman-Codeworte sind.

12. Vorrichtung nach einem der vorhergehenden Ansprüche, bei der die Codeworte Informationssymbole darstellen, und Codeworte des ersten Satzes bedeutsamere Informationssymbole darstellen als Codeworte des zweiten Satzes oder weiterer Sätze.

13. Vorrichtung nach Anspruch 12, bei der die Informationssymbole Spektralwerte eines Audiosignals sind, und die Codeworte des ersten Satzes psychoakustisch bedeutsame Spektralwerte darstellen, die vor einer Fehlerfortpflanzung aufgrund eines Übertragungsfehlers in dem Datenstrom zu schützen sind.

14. Verfahren (10) zum Erzeugen eines Datenstroms (38), der eine Vielzahl von Rasterpunkten (41 - 47) als Bezugspunkte aufweist, wobei die Rasterpunkte ein Raster festlegen, wobei zwei benachbarte Rasterpunkte ein Segment definieren, aus Codeworten unterschiedlicher Länge, die in eine Mehrzahl von Sätzen von Codeworten aufgeteilt sind, mit folgenden Schritten:
Schreiben zumindest eines Teils eines jeden Codeworts eines ersten Satzes von Codeworten in den Datenstrom in einer ersten Schreibrichtung von jeweils einem ersten Rasterpunkt eines Segments aus;
Schreiben zumindest eines Teils eines Codeworts eines zweiten Satzes von Codeworten in den Datenstrom in einer der ersten Schreibrichtung entgegengesetzten zweiten Schreibrichtung von jeweils einem zweiten Rasterpunkt eines Segments aus, wobei die Codeworte des zweiten Satzes nach einer vorbestimmten Zuordnungsvorschrift Segmenten zugeordnet sind, derart, daß jedes Codewort des zweiten Satzes einem unterschiedlichen Segment zugeordnet ist, wobei für den Fall, daß ein Codewort (7) des zweiten Satzes nicht oder nicht vollständig in das zugeordnete Segment paßt, zumindest ein Teil dieses Codeworts oder zumindest ein Teil des Rests (7b) dieses Codeworts, der nicht in das zugeordnete Segment paßt, nach einer vorbestimmten Vorschrift in ein nicht vollbesetztes anderes Segment in der ersten oder zweiten Schreibrichtung geschrieben wird, nachdem alle verbleibenden Segmente mit den anderen Codeworten des zweiten Satzes abgearbeitet sind.

15. Verfahren (30) zum Lesen eines Datenstroms (38), der eine Vielzahl von Rasterpunkten als Bezugspunkte aufweist, wobei die Rasterpunkte ein Raster festlegen, wobei zwei benachbarte Rasterpunkte ein Segment definieren, bei der der Datenstrom eine Mehrzahl von Sätzen von Codeworten aufweist, wobei ein erster Satz von Codeworten in der ersten Richtung geschrieben ist und ein zweiter Satz von Codeworten in einer zweiten Richtung geschrieben ist, wobei die Codeworte des zweiten Satzes Segmenten des Datenstroms nach einer vorbestimmten Zuordnungsvorschrift zugeordnet sind, derart, daß jedes Codewort eines Satzes einem anderen Segment zugeordnet ist, und wobei ein Codewort des zweiten Satzes nach einer vorbestimmten Vorschrift über mehr als ein Segment aufgeteilt sein kann, mit folgenden Merkmalen:
Lesen der Codeworte des ersten Satzes von einem ersten Rasterpunkt eines Segments aus in einer ersten Leserichtung, die der ersten Schreibrichtung entspricht;
Lesen der Codeworte des zweiten Satzes von einem zweiten Rasterpunkt eines Segments aus in einer zur ersten Leserichtung entgegengesetzten zweiten Leserichtung, wobei zum Lesen der Codeworte des zweiten Satzes gemäß der vorbestimmten Zuordnungsvorschrift zu dem zweiten Rasterpunkt eines Segments gesprungen wird, wobei, nachdem sämtliche Segmente nach Codeworten des zweiten Satzes durchsucht worden sind und zumindest ein Codewort des zweiten Satzes nicht vorhanden oder nicht vollständig ist, zumindest in ein weiteres Segment nach der vorbestimmten Vorschrift gesprungen wird, um das zumindest eine Codewort des zweiten Satzes vollständig oder einen Teil des zumindest einen Codeworts zu erhalten.

## Claims

1. Apparatus (10) for producing a data stream (38), which comprises a multitude of raster points (41 - 47) as reference points, the raster points specifying a raster, two adjacent raster points defining a segment, of code words of variable lengths which are divided up into a plurality of sets of code words, the apparatus comprising the following:
a first device (16) for writing at least a part of each code word of a first set of code words into the data stream in a first direction of writing, starting at a first raster point of a segment, respectively;
a second device (18) for writing at least a part of a code word of a second set of code words into the data stream in a second direction of writing which is opposite to the first direction of writing, starting from a second raster point of a segment, respectively, the code words of the second set being assigned to segments in accordance with a predetermined assignment rule, such that each code word of the second set is assigned to a different segment,
wherein, in case that a code word (7) of the second set does not or not completely fit into the assigned segment, at least a part of this code word or at least a part of the remainder (7b) of this code word which does not fit into the assigned segment is written into a different, not fully occupied segment, in accordance with a predetermined rule, by the first device (16) or the second device (18), after the second device (18) for writing has processed all remaining segments with the other code words of the second set.

2. Apparatus as claimed in claim 1, wherein the first writing device (16) is arranged so as to write a starting section of a code word, and wherein the second writing device (18) is arranged so as to write at least a part of the remainder of the same code word.

3. Apparatus as claimed in claim 1, wherein the first writing device (16) is arranged so as to write a starting section of a first code word at a first raster point of a first segment, and to write a starting section of a second code word at a first raster point of a following segment, and wherein the second writing device (18) is arranged so as to write at least a part of the remainder of the first code word, starting from the second raster point of the second segment, and/or the remainder of the second code word, starting from the second raster point of a further segment.

4. Apparatus as claimed in claim 1, wherein the second writing device (18) is arranged so as to write starting from the second raster point of the segment, into which the first writing device (16) has written, wherein, if the corresponding code word (7) of the second set is longer than a vacant space in the segment, part (7a) of the code word of the second set which fits into the vacant space is written into the segment, and the remainder (7b) is initially stored.

5. Apparatus as claimed in any of the preceding claims, wherein the second writing device (18) is arranged so as to become active only once all code words of the first set have been written into the data stream.

6. Apparatus as claimed in claim 4 or 5, wherein the second writing device (18) is arranged so as to write at least a part of the remainder (7b) of the code word of the second set into the data stream, starting from the end of a different code word (8) of the second set.

7. Apparatus as claimed in any of claims 1 to 6, wherein the code words are divided up into at least three sets, wherein the first or the second writing device (16, 18) are further arranged so as to write the third set starting from ends of the code words of the first and the second set, respectively.

8. Apparatus as claimed in claim 7, wherein the first or the second writing device (16, 18) is further arranged so as to write the third set starting from ends of the code words of the first and second set, respectively, in accordance with a predetermined assignment rule, such that each code word of the third set is assigned to a different segment.

9. Apparatus (23) for reading a data stream (38) which comprises a multitude of raster points as reference points, the raster points specifying a raster, two adjacent raster points defining a segment, wherein the data stream comprises a plurality of sets of code words, a first set of code words being written in the first direction and a second set of code words being written in a second direction, the code words of the second set being assigned to segments of the data stream in accordance with a predetermined assignment rule, such that each code word of a set being assigned to a different segment, wherein a code word of the second set may be divided up over more than one segment in accordance with a predetermined rule, the apparatus comprising the following:
a first device (26) for reading in a first direction of reading which corresponds to the first direction of writing;
a second device (27) for reading in a second direction of reading which is opposite to the first direction of reading; and
a control device (28)
for supplying the code words of the first set to the first reading device (26), each code word of the first set starting at the first raster point of a segment, and
for supplying the code words of the second set to the second reading device (27), wherein one jumps to the second raster point of a segment in accordance with the predetermined assignment rule, and
wherein, after all segments have been searched for code words of the second set and at least one code word of the second set is not present or not complete, one jumps at least to one further segment in accordance with the predetermined rule in order to obtain the at least one code word of the second set completely or a part of the at least one code word.

10. Apparatus as claimed in claim 9, wherein, if only one starting section of a code word is read by a writing device in a segment, this starting section is stored.

11. Apparatus as claimed in any of the preceding claims, wherein the code words are Huffman code words.

12. Apparatus as claimed in any of the preceding claims, wherein the code words represent information symbols, and code words of the first set represent more significant information symbols than code words of the second set or of further sets.

13. Apparatus as claimed in claim 12, wherein the information symbols are spectral values of an audio signal, and wherein the code words of the first set are spectral values which are significant from a psycho-acoustic point of view and which are to be protected from error propagation due to a transmission error in the data stream.

14. Method (10) for producing a data stream (38) which comprises a multitude of raster points (41 - 47) as reference points, the raster points specifying a raster, two adjacent raster points defining a second, of code words of variable lengths which are divided up into a plurality of sets of code words, the method comprising the following steps:
writing at least a part of each code word of a first set of code words into the data stream in a first direction of writing, starting from a first raster point of a segment, respectively;
writing at least a part of a code word of a second set of code words into the data stream in a second direction of writing, which is opposite to the first direction of writing, starting from a second raster point of a segment, respectively, the code words of the second set being assigned to segments in accordance with the predetermined assignment rule, such that each code word of the second set is assigned to a different segment, wherein, in case a code word (7) of the second set does not or not completely fit into the assigned segment, at least a part of this code word or at least a part of the remainder (7b) of this code word which does not fit into the assigned segment is written into a different, not fully occupied segment in the first or second direction of writing, in accordance with a predetermined regulation, after all remaining segments have been processed with the other code words of the second set.

15. Method (30) for reading a data stream (38) which comprises a multitude of raster points as reference points, the raster points specifying a raster, two adjacent raster points defining a segment, in which method the data stream comprises a plurality of sets of code words, a first set of code words being written in the first direction and a second set of code words being written in a second direction, the code words of the second set being assigned to segments of the data stream in accordance with a predetermined assignment rule, such that each code word of a set is assigned to a different segment, wherein a code word of the second set may be divided up over more than one segment in accordance with a predetermined regulation, the method comprising the following steps:
reading the code words of the first set, starting from a first raster point of a segment, in a first direction of reading which corresponds to the first direction of writing;
reading the code words of the second set, starting from a second raster point of a segment, in a second direction of reading which is opposite to the first direction of reading, wherein one jumps, for reading the code words of the second set to the second raster point of a segment in accordance with the predetermined assignment rule, wherein, after all segments have been searched for code words of the second set or at least a code word of the second set is not present or not completely present, one jumps to at least one further segment in accordance with the predetermined rule so as to obtain the at least one code word of the second set completely or a part of the at least one code word.

## Revendications

1. Dispositif (10) pour produire un flux de données (38) présentant une pluralité de points de trame (41 à 47) comme points de référence, les points de trame déterminant une trame, deux points de trame adjacents définissant un segment constitué de mots de code de longueur différente divisés en une pluralité de jeux de mots de code, aux caractéristiques suivantes :
un premier dispositif (16) pour écrire au moins une partie de chaque mot de code d'un premier jeu de mots de code dans le flux de données, dans une première direction d'écriture à partir de chaque fois un premier point de trame d'un segment ;
un second dispositif (18) pour écrire au moins une partie d'un mot de code d'un second jeu de mots de code dans le flux de données, dans une seconde direction d'écriture, opposée à la première direction d'écriture, à partir de chaque fois un second point de trame d'un segment, les mots de code du second jeu étant associés à des segments, selon une spécification d'association prédéterminée, de telle sorte que chaque mot de code du second jeu soit associé à un segment différent,
où, au cas où un mot de code (7) du second jeu ne s'intègre pas ou ne s'intègre pas totalement dans le segment associé, au moins une partie de ce mot de code ou au moins une partie du reste (7b) de ce mot de code qui ne s'intègre pas dans le segment associé est écrite, selon une spécification prédéterminée, dans un autre segment non entièrement occupé par le premier dispositif (16) ou le second dispositif, après que le second dispositif (18) pour écrire a fini de traiter tous les segments restants par les autres mots de code du second jeu.

2. Dispositif selon la revendication 1, dans lequel le premier dispositif d'écriture (16) est disposé pour écrire un segment initial d'un mot de code, et dans lequel le second dispositif d'écriture (18) est disposé pour écrire au moins une partie du reste du même mot de code.

3. Dispositif selon la revendication 1, dans lequel le premier dispositif d'écriture (16) est disposé pour écrire un segment initial d'un mot de code à un premier point de trame d'un premier segment et un segment initial d'un second mot de code à un premier point de trame d'un segment suivant, et dans lequel le second dispositif d'écriture (18) est disposé pour écrire au moins une partie du reste du premier mot de code à partir du second point de trame du second segment ou le reste du second mot de code à partir du second point de trame d'un second segment.

4. Dispositif selon la revendication 1, dans lequel le second dispositif d'écriture (18) est disposé pour écrire, partant du second point de trame du segment dans lequel a écrit le premier dispositif d'écriture (16), au cas où le mot de code correspondant (7) du second jeu est plus long qu'un emplacement libre dans le segment, la partie (7a) du mot de code du second jeu s'intégrant dans l'emplacement libre étant écrite dans le segment et le reste (7b) étant tout d'abord mémorisé.

5. Dispositif selon l'une des revendications précédentes, dans lequel le second dispositif d'écriture (18) est disposé pour ne devenir actif que lorsque tous les mots de code du premier jeu ont été écrits dans le flux de données.

6. Dispositif selon la revendication 4 ou 5, dans lequel le second dispositif d'écriture (18) est disposé pour écrire dans le flux de données au moins une partie du reste (7b) du mot de code du second jeu à partir de la fin d'un autre mot de code (8) du second jeu.

7. Dispositif selon l'une des revendications 1 à 6, dans lequel les mots de code sont subdivisés en au moins trois jeux, dans lequel le premier ou le second dispositif d'écriture (16, 18) est, par ailleurs, disposé pour écrire le troisième jeu à partir des fins des mots de code du premier ou du second jeu.

8. Dispositif selon la revendication 7, dans lequel le premier ou le second dispositif d'écriture (16, 18} est, par ailleurs, disposé pour écrire le troisième jeu à partir des fins des mots de code du premier ou du second jeu selon une spécification prédéterminée, de sorte que chaque mot de code du troisième jeu soit associé à un autre segment.

9. Dispositif (23) pour lire un flux de données (38) présentant une pluralité de points de trame comme points de référence, les points de trame déterminant une trame, deux points de trame adjacents définissant un segment, dans lequel le flux de données présente une pluralité de jeux de mots de code, un premier jeu de mots de code étant écrit la première direction et un second jeu de mots de code étant écrit dans une seconde direction, les mots de code du second jeu étant associés à des segments du flux de données selon une spécification d'association prédéterminée, de telle sorte que chaque mot de code d'un jeu soit associé à un autre segment, un mot de code du second jeu pouvant, selon une spécification prédéterminée, être divisé sur plus d'un segment, aux caractéristiques suivantes :
un premier dispositif (26) pour lire dans une première direction de lecture correspondant à la première direction d'écriture ;
un second dispositif (27) pour lire dans une seconde direction de lecture, opposée à la première direction de lecture ; et
un dispositif de commande (28)
pour fournir les mots de code du premier jeu au premier dispositif de lecture (26), chaque mot de code du premier jeu commençant au premier point de trame d'un segment, et
pour fournir les mots de code du second jeu au second dispositif de lecture (27), un saut au second point de trame d'un segment étant effectué, selon la prescription d'association prédéterminée, et
où, après que tous les segments ont été examinés pour trouver des mots de code du second jeu et si au moins un mot de code du second jeu n'est pas présent ou n'est pas complet, un saut est effectué au moins à un autre segment, selon la prescription prédéterminée, pour obtenir l'au moins un mot de code du second jeu complet ou une partie de l'au moins un mot de code.

10. Dispositif selon la revendication 9, dans lequel, lorsque seul un segment initial d'un mot de code dans un segment est lu par un dispositif d'écriture, ce segment initial est mémorisé.

11. Dispositif selon l'une des revendications précédentes, dans lequel les mots de code sont des mots de code de Huffman.

12. Dispositif selon l'une des revendications précédentes, dans lequel les mots de code représentent des symboles d'informations et les mots de code du premier jeu représentent des symboles d'informations plus importantes que les mots de code du second jeu ou d'autres jeux.

13. Dispositif selon la revendication 12, dans lequel les symboles d'informations sont des valeurs spectrales d'un signal audio, et les mots de code du premier jeu représentent des valeurs spectrales acoustiquement significatives devant être protégées contre une propagation d'erreur par suite d'une erreur de transmission dans le flux de données.

14. Procédé (10) pour produire un flux de données (38) présentant une pluralité de points de trame (41 à 47) comme points de référence, les points de trame déterminant une trame, deux points de trame adjacents définissant un segment constitué de mots de code de longueur différente divisés en une pluralité de jeux de mots de code, aux étapes suivantes consistant à :
écrire au moins une partie de chaque mot de code d'un premier jeu de mots de code dans le flux de données, dans une première direction d'écriture à partir de chaque fois un premier point de trame d'un segment ;
écrire au moins une partie d'un mot de code d'un second jeu de mots de code dans le flux de données, dans une seconde direction d'écriture, opposée à la première direction d'écriture, à partir de chaque fois un second point de trame d'un segment, les mots de code du second jeu étant associés à des segments, selon une spécification d'association prédéterminée, de telle sorte que chaque mot de code du second jeu soit associé à un segment différent, où, au cas où un mot de code (7) du second jeu ne s'intègre pas ou ne s'intègre pas totalement dans le segment associé, au moins une partie de ce mot de code ou au moins une partie du reste (7b) de ce mot de code qui ne s'intègre pas dans le segment associé est écrite, selon une spécification prédéterminée, dans un autre segment non entièrement occupé dans le premier ou le second dispositif, après que tous les segments restants aient été finis par les autres mots de code du second jeu.

15. Procédé (30) pour lire un flux de données (38) présentant une pluralité de points de trame comme points de référence, les points de trame déterminant une trame, deux points de trame adjacents définissant un segment, dans lequel le flux de données présente une pluralité de jeux de mots de code, un premier jeu de mots de code étant écrit la première direction et un second jeu de mots de code étant écrit dans une seconde direction, les mots de code du second jeu étant associés à des segments du flux de données selon une spécification d'association prédéterminée, de telle sorte que chaque mot de code d'un jeu soit associé à un autre segment, et un mot de code du second jeu pouvant, selon une spécification prédéterminée, être divisé sur plus d'un segment, aux caractéristiques suivantes :
lire les mots de code du premier jeu à partir d'un premier point de trame d'un segment, dans une première direction de lecture correspondant à la première direction d'écriture ;
lire les mots de code du second jeu à partir d'un second point de trame d'un segment, dans une seconde direction de lecture, opposée à la première direction de lecture, où, pour la lecture des mots de code du second jeu, un saut est effectué au second point de trame d'un segment, selon la prescription prédéterminée, où, après que tous les segments ont été examinés pour trouver des mots de code du second jeu et si au moins un mot de code du second jeu n'est pas présent ou n'est pas complet, un saut est effectué au moins à un autre segment, selon la prescription prédéterminée, pour obtenir l'au moins un mot de code du second jeu complet ou une partie de l'au moins un mot de code.
